(19) Europäisches Patentamt / European Patent Office / Office européen des brevets

(11) **EP 4 350 029 A1**

(12) **EUROPEAN PATENT APPLICATION**
published in accordance with Art. 153(4) EPC

(43) Date of publication:
**10.04.2024 Bulletin 2024/15**

(21) Application number: **22810872.6**

(22) Date of filing: **21.02.2022**

(51) International Patent Classification (IPC):
**C23C 14/34** (2006.01)    **C04B 35/495** (2006.01)
**G02B 5/22** (2006.01)

(52) Cooperative Patent Classification (CPC):
**C04B 35/495; C23C 14/34; G02B 5/22**

(86) International application number:
**PCT/JP2022/006841**

(87) International publication number:
**WO 2022/249591 (01.12.2022 Gazette 2022/48)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.05.2021 JP 2021087479**

(71) Applicant: **SUMITOMO METAL MINING CO., LTD.
Tokyo
105-8716 (JP)**

(72) Inventor: **OKAMI, Hideharu
Tokyo 105-8716 (JP)**

(74) Representative: **TBK
Bavariaring 4-6
80336 München (DE)**

(54) **SPUTTERING TARGET AND METHOD FOR FORMING CESIUM TUNGSTEN OXIDE FILM**

(57)    [Object] Provided is a sputtering target that makes it possible to set $n_{Cs}/n_W$(film) expressing a ratio of Cs atoms to W atoms in a cesium tungsten oxide film formed by a sputtering method within such a desired range (0.3 or more to 0.36 or less) that the film can exhibit high transmittance in the visible wavelength region and absorption in the near-infrared wavelength region.

    [Solution] This target contains Cs and W. When [T-S distance] denotes a distance between the target and a substrate for film formation and P denotes a pressure in an atmosphere during film formation by sputtering and $n_W$ denotes the number of W atoms and $n_{Cs}$ denotes the number of Cs atoms contained in the target, $n_{Cs}/n_W$(T) expressing a ratio of Cs atoms to W atoms in the target satisfies the following (Formula 1) with respect to [T-S distance] and P:

$$0.09/\{(-0.00161 \times [\text{T-S distance}] + 0.00559)$$
$$\times P + 0.346\}$$
$$\leq n_{Cs}/n_W(T) \leq$$
$$0.13/\{(-0.00161 \times [\text{T-S distance}] + 0.00559)$$
$$\times P + 0.346\} \quad (\text{Formula 1})$$

# FIG.5

TRANSMITTANCE (FILM THICKNESS : 400nm)

**Description**

TECHNICAL FIELD

The present invention relates to a sputtering target and a method for forming a cesium tungsten oxide film for use to form, by sputtering, a cesium tungsten oxide film having high transmittance in a visible wavelength region and absorption in a near-infrared wavelength region and also having radio wave transmittance, and in particular relates to a sputtering target and a method for forming a cesium tungsten oxide film with which $n_{Cs}/n_W$ expressing a ratio of cesium (Cs) atoms to tungsten (W) atoms in a cesium tungsten oxide film (where $n_W$ is the number of W atoms in the cesium tungsten oxide film and $n_{Cs}$ is the number of Cs atoms in the cesium tungsten oxide film) is set within a desired range.

BACKGROUND ART

In recent years, in order to reduce the energy consumption of air conditioners indoors and in transportation means such as vehicles in summer, the development of a heat-ray shielding technique for windows that let in outside light has been advancing. As means for this technique, there are methods such as a method for attaching a film (light-shielding member) to a window, the film having a colored film or optical thin film having a heat-ray shielding effect formed therein, a method for coating a window with a substance having a heat-ray shielding effect, and a method for employing a window on which an optical thin film having a heat-ray shielding effect is formed by vapor deposition, sputtering, or the like. Among them, the method for employing a window on which an optical thin film having a heat-ray shielding effect is formed by vapor deposition, sputtering, or the like is a method capable of forming an optical thin film having high durability although it is not capable of coating an existing window with an optical thin film.
For example, as the above light shielding member for a window material or the like, Patent Literature 1 describes a film having a mirror surface state (light shielding member) and obtained by forming a metal film of aluminum or the like by vapor deposition. However, since the appearance of a light shielding member is in a semi-transparent mirror state, outdoor use of this light shielding member causes a problem in the scenery because the reflection is too dazzling. In addition, having high conductivity, the metal film of aluminum or the like reflects radio waves, making it difficult to connect devices that use radio waves, such as mobile phones, smart phones, and GPS (Global Positioning System)-using devices.
Meanwhile, as the above coating method with a substance having a heat-ray shielding effect, the present applicant has proposed an infrared shielding fine particle dispersion containing composite tungsten oxide fine particles represented by a general formula MxWyOz (M is one or more kinds of elements selected from alkali metals, W is tungsten, and O is oxygen, where $0.001 \leq x/y \leq 1$ and $2.2 \leq z/y \leq 3.0$) described in Patent Literature 2. The composite tungsten oxide fine particles efficiently absorb sunlight rays, especially light in the near-infrared region, and additionally have high transparency to visible light. The above infrared shielding fine particle dispersion is for forming a thin film by: dispersing the composite tungsten oxide fine particles in an appropriate solvent to obtain a dispersion liquid; adding a medium resin to the obtained dispersion liquid; and then coating a substrate surface with the resultant dispersion liquid, and has both heat-ray shielding properties and radio wave transmittance. However, the method described in Patent Literature 2 is to form the thin film by the coating method and therefore has a problem of requiring advanced coating technique in order to control the film thickness and ensure the film thickness uniformity and flatness over a large area.
In addition, as the method by sputtering or the like, Patent Literature 3 discloses a vehicle window glass and a production method thereof, and proposes a vehicle window glass produced by sequentially forming, for example, a first metal oxide film (ITO)/a first Ag film/a second metal oxide film (ITO)/a second Ag film/a third metal oxide film (ITO) by use of a large in-line sputtering apparatus capable of processing large-area substrates of vehicle window glasses, and Patent Literature 4 proposes a composite tungsten oxide film derived from film formation by sputtering (the composite tungsten oxide film represented by the above general formula MxWyOz).

CITATION LIST

Patent Literatures

Patent Literature 1: Japanese Patent Application Publication No. H05-113085
Patent Literature 2: Japanese Patent No. 4096205
Patent Literature 3: Japanese Patent Application Publication No. 2002-020142
Patent Literature 4: Japanese Patent No. 6540859

## SUMMARY OF INVENTION

### TECHNICAL PROBLEM

When a kind of composite tungsten oxide represented by the general formula MxWyOz, specifically, a cesium tungsten oxide film (a cesium tungsten oxide film in which M in the general formula MxWyOz is an alkali metal, cesium) is formed by the sputtering method described in Patent Literature 4, the chemical composition of the formed cesium tungsten oxide film differs from the chemical composition of the cesium tungsten oxide constituting the sputtering target in some cases.

To be more specific, $n_{Cs}/n_W$ expressing a ratio of and cesium (Cs) atoms to tungsten (W) atoms in the formed cesium tungsten oxide film ($n_W$ is the number of W atoms in the formed cesium tungsten oxide film and $n_{Cs}$ is the number of Cs atoms) differs from $n_{Cs}/n_W$ expressing a ratio of Cs atoms to W atoms in the cesium tungsten oxide constituting the sputtering target, and $n_{Cs}/n_W$ in the cesium tungsten oxide film deviates from a desired range (0.3 or more to 0.36 or less). This results in problems of deteriorating the properties of the cesium tungsten oxide film, that is, high transmittance in the visible wavelength region and absorption in the near-infrared wavelength region.

The present invention was made in view of the above problems and has an object to provide a sputtering target with which $n_{Cs}/n_W$ expressing the ratio of Cs atoms to W atoms in a cesium tungsten oxide film is set within such a desired range (0.3 or more to 0.36 or less) that the cesium tungsten oxide film can exhibit high transmittance in the visible wavelength region and absorption in the near-infrared wavelength region, and to provide a method for forming a cesium tungsten oxide film having high transmittance in the visible wavelength region and absorption in the near-infrared wavelength region and also having radio wave transmittance.

### SOLUTION TO PROBLEM

As a result of earnest studies by the present inventor to achieve the above object, the present inventor found out that $n_{Cs}/n_W$ expressing the ratio of Cs atoms to W atoms in a cesium tungsten oxide film formed on a substrate for film formation by a sputtering method is determined depending on not only a condition of $n_{Cs}/n_W$ expressing the ratio of Cs atoms to W atoms in a sputtering target as a film formation material, but also a distance between the sputtering target and the substrate for film formation during film formation by sputtering and a pressure condition in an atmosphere during the film formation by sputtering, and confirmed that, in order that the above $n_{Cs}/n_W$ expressing the ratio of Cs atoms to W atoms in the cesium tungsten oxide film can be set within the desired range (0.3 or more to 0.36 or less), it is necessary to adjust the condition of $n_{Cs}/n_W$ expressing the ratio of Cs atoms to W atoms in the sputtering target, the distance between the sputtering target and the substrate for film formation during the film formation by sputtering, and the pressure condition in the atmosphere during the film formation by sputtering.

Hereinafter, the above $n_{Cs}/n_W$ expressing the ratio of Cs atoms to W atoms in the cesium tungsten oxide film will be abbreviated as $n_{Cs}/n_W$(film) and the above $n_{Cs}/n_W$ expressing the ratio of Cs atoms to W atoms in the cesium tungsten oxide constituting the sputtering target will be abbreviated as $n_{Cs}/n_W$(T) in some cases.

As a result of repeating an experiment by the present inventor, the present inventor found out that the above $n_{Cs}/n_W$(film) in a cesium tungsten oxide film can be set within a desired range (0.3 or more to 0.36 or less) in a case where the above $n_{Cs}/n_W$(T) in a sputtering target satisfies the following (Formula 1) with respect to the distance between the sputtering target and a substrate for film formation during film formation by sputtering (hereinafter will be abbreviated as [T-S distance]) and a pressure P in an atmosphere during the film formation by sputtering:

```
0.09/{(-000161 × [T-S distance] + 0.00559) × P +

0.346}

      ≤ nCs/nW(T) ≤

0.13/{(-000161 × [T-S distance] + 0.00559) × P +

0.346}       (Formula 1)
```

The present invention was completed based on the experiment and technical analysis conducted by the present inventor.

Specifically, according to the present invention, a first invention is a sputtering target for use to form a cesium tungsten oxide film on a substrate for film formation by a sputtering method, in which

the sputtering target includes cesium (Cs) and tungsten (W), and

when [T-S distance] denotes a distance between the sputtering target and the substrate for film formation and P denotes a pressure in an atmosphere during film formation by sputtering, and $n_W$ denotes the number of W atoms and $n_{Cs}$ denotes the number of Cs atoms contained in the sputtering target,

$n_{Cs}/n_W(T)$ expressing a ratio of Cs atoms to W atoms in the sputtering target satisfies the following (Formula 1) with respect to [T-S distance] and P defined above:

$$0.09/\{(-000161 \times [\text{T-S distance}] + 0.00559) \times P + 0.346\}$$

$$\leq n_{Cs}/n_W(T) \leq$$

$$0.13/\{(-000161 \times [\text{T-S distance}] + 0.00559) \times P + 0.346\} \quad (\text{Formula 1}).$$

According to the present invention:

a second invention is the sputtering target according to the first invention, including a cesium tungsten oxide sintered compact produced from a cesium tungsten oxide powder;

a third invention is the sputtering target according to the first invention, including a thermally sprayed film of a cesium tungsten oxide powder;

a fourth invention is the sputtering target according to the second or third invention, in which the cesium tungsten oxide powder is made of raw materials which are a metal or compound as a cesium source and a metal or compound as a tungsten source;

a fifth invention is the sputtering target according to the fourth invention, in which the compound as the cesium source is an oxide, a carbonate, or a chloride; and

a sixth invention is the sputtering target according to the fourth invention, in which the compound as the tungsten source is an oxide or a carbonate.

Next, according to the present invention, a seventh invention is a method for forming a cesium tungsten oxide film on a substrate for film formation by using the sputtering target according to any one of the first invention to sixth invention, in which

the distance [T-S distance] between the sputtering target and the substrate for film formation during the film formation by sputtering is 60 mm or longer to 140 mm or shorter; and

an eighth invention is the method for forming a cesium tungsten oxide film according to the seventh invention, in which the pressure P in the atmosphere during the film formation by sputtering is 0.2 Pa or higher to 0.8 Pa or lower.

ADVANTAGEOUS EFFECTS OF INVENTION

With the sputtering target according to the present invention, $n_{Cs}/n_W(T)$ expressing the ratio of Cs atoms to W atoms in the sputtering target satisfies the following (Formula 1) with respect to [T-S distance] and P:

$$0.09/\{(-000161 \times [\text{T-S distance}] + 0.00559) \times P + 0.346\}$$

$$\leq n_{Cs}/n_W(T) \leq$$

$$0.13/\{(-000161 \times [\text{T-S distance}] + 0.00559) \times P + 0.346\} \quad (\text{Formula 1}).$$

For this reason, $n_{Cs}/n_W(\text{film})$ expressing the ratio of Cs atoms to W atoms in a cesium tungsten oxide film formed by using this sputtering target is set within such a desired range (0.3 or more to 0.36 or less) that the cesium tungsten oxide film can exhibit high transmittance in the visible wavelength region and absorption in the near-infrared wavelength region.

Therefore, use of the sputtering target according to the present invention makes it possible to form a cesium tungsten oxide film having high transmittance in the visible wavelength region and absorption in the near-infrared wavelength region and also having radio wave transmittance on a substrate for film formation.

BRIEF DESCRIPTION OF THE DRAWINGS

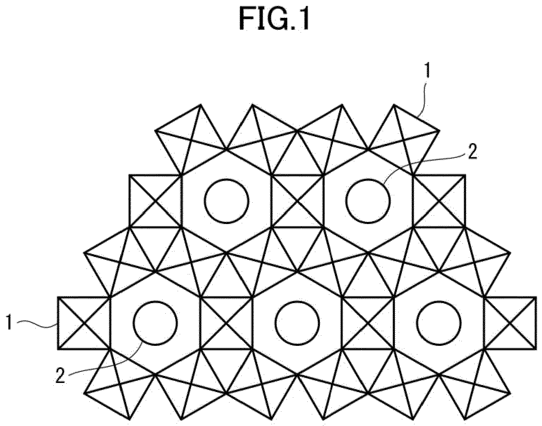

[Fig. 1] Fig. 1 is a schematic view illustrating a composite tungsten oxide having a hexagonal crystal system.

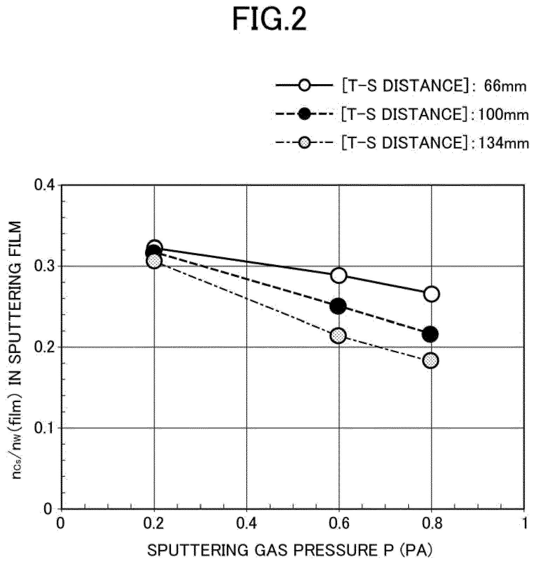

[Fig. 2] Fig. 2 is a graph presenting a relationship of $n_{Cs}/n_W$(film) expressing a ratio of Cs atoms to W atoms in each of sputtering films (cesium tungsten oxide films), which were formed by: using a sputtering target produced by sintering a $Cs_{0.33}WO_3$ fine particle powder; setting a distance [T-S distance] between the sputtering target and a substrate for film formation to 66 mm, 100 mm, and 134 mm; and setting a pressure P (Pa) of a sputtering gas to 0.2 (Pa), 0.6 (Pa), and 0.8 (Pa), with [T-S distance] and the pressure P of the sputtering gas.

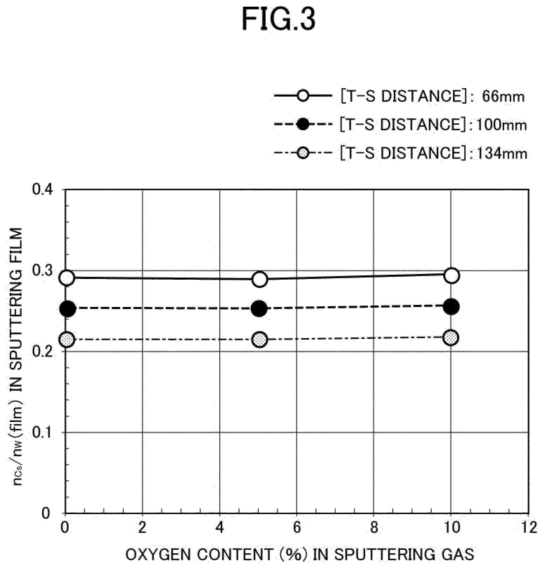

[Fig. 3] Fig. 3 is a graph presenting a relationship of $n_{Cs}/n_W$(film) expressing a ratio of Cs atoms to W atoms in each of sputtering films (cesium tungsten oxide films), which were formed by: using a sputtering target produced by sintering a $Cs_{0.33}WO_3$ fine particle powder; setting the distance [T-S distance] between the sputtering target and a substrate for film formation to 66 mm, 100 mm, and 134 mm; and setting the pressure P (Pa) of a sputtering gas to 0.6 (Pa), with [T-S distance] and an oxygen concentration (%) in the sputtering gas.

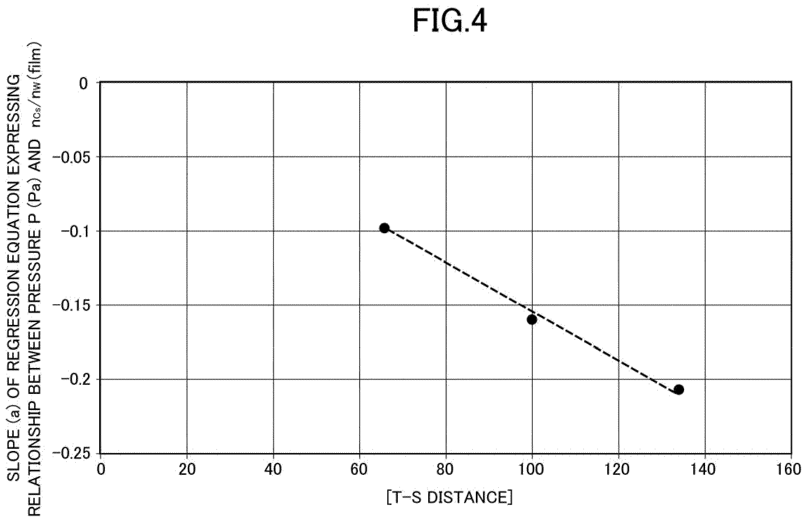

[Fig. 4] Fig. 4 is a graph presenting a relationship between [T-S distance] and the slope (a) of the regression $[n_{Cs}/n_W(film) = aP + 0.346]$ expressing the relationship between the pressure P (Pa) of the sputtering gas and $n_{Cs}/n_W$(film) in the sputtering film (cesium tungsten oxide film) in Fig. 2.

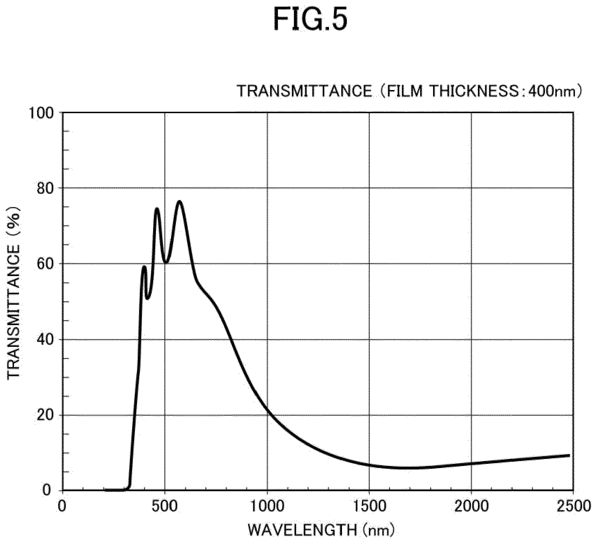

[Fig. 5] Fig. 5 is a graph presenting a relationship between wavelength and transmittance (%) of a heat-ray shielding film according to Example.

BEST MODES FOR PRACTICING THE INVENTION

Hereinafter, embodiments according to the present invention will be described in detail.

1. Composite Tungsten Oxide Film

A cesium tungsten oxide film according to the present invention, which is of one type of composite cesium tungsten oxides represented by a general formula MxWyOz (M is one or more kinds of elements selected from alkali metals and so on, W is tungsten, and O is oxygen, where $0.001 \leq x/y \leq 1$ and $2.2 \leq z/y \leq 3.0$), contains cesium (Cs), tungsten (W), and oxygen (O).

In the technique related to the infrared shielding using composite tungsten oxide fine particles proposed by the present applicant, which is described in detail in Patent Literature 2 as described above, it is necessary that a composite tungsten oxide film contain, as a main component, a composite tungsten oxide satisfying the above composition ranges so that the composite tungsten oxide film can obtain high transmittance in the visible wavelength region and absorption in the near-infrared wavelength region. The basic optical properties of the composite tungsten oxide film are derived from a theoretically-calculated atomic arrangement of an element(s) M (M is one or more kinds of elements selected from H, He, alkali metals, alkaline earth metals, rare earth elements, Mg, Zr, Cr, Mn, Fe, Ru, Co, Rh, Ir, Ni, Pd, Pt, Cu, Ag, Au, Zn , Cd, Al, Ga, In, Tl, Si, Ge, Sn, Pb, Sb, B, F, P, S, Se, Br, Te, Ti, Nb, V, Mo, Ta, Re, Be, Hf, Os, Bi, and I), tungsten (W), and oxygen (O). Specifically, when the composite tungsten oxide fine particles have a hexagonal crystal structure, the fine particles achieve improved transmittance in the visible light region and improved absorption in the near-infrared region. Here, the composite tungsten oxide fine particles may be crystalline or amorphous.

When the composite tungsten oxide fine particles having the hexagonal crystal structure have a uniform crystal structure, the amount of the element M added is preferably 0.2 or more to 0.5 or less and more preferably 0.33 per 1 tungsten (W). Theoretically, when the composite tungsten oxide is $M_{0.33}WO_3$, it is considered that in unit structures of the composite tungsten oxide illustrated in Fig. 1 (each structure in which six octahedra each formed of a $WO_6$ unit 1 are aggregated to form a hexagonal gap and an element M2 is arranged in the gap), the elements M added are arranged in all the hexagonal gaps.

In practice, in the case of the cesium tungsten oxide film according to the present invention, the value of cesium (Cs) per 1 tungsten (W) may be around 0.33, that is, 0.22 or more to 0.37 or less, and more preferably 0.3 or more to 0.36 or less. In other words, when the above $n_{Cs}/n_W$(film) expressing the ratio of Cs atoms to W atoms in a cesium tungsten oxide film is within a range of 0.22 or more to 0.37 or less and preferably 0.3 or more to 0.36 or less, the cesium tungsten oxide film has a hexagonal crystal structure and this cesium tungsten oxide film has high transmittance in the visible wavelength region and absorption in the near-infrared wavelength region.

2. Problem in Cesium Tungsten Oxide Film Formation by Sputtering

The present inventor repeatedly conducted sputtering tests using a sputtering target produced by sintering a $Cs_{0.33}WO_3$ fine particle powder [that is, $n_{Cs}/n_W(T)$ expressing the ratio of Cs atoms to W atoms is 0.33]. As a result, the present inventor confirmed that $n_{Cs}/n_W(film)$ expressing the ratio of Cs atoms to W atoms in the cesium tungsten oxide film formed was significantly smaller than 0.33 depending on the distance [T-S distance] between the sputtering target and a glass substrate as a substrate for film formation and a pressure P condition of a sputtering gas.

Specifically, Fig. 2 presents a relationship of $n_{Cs}/n_W(film)$ in each of cesium tungsten oxide films, which were formed by film formation by sputtering using the sputtering target produced by sintering the $Cs_{0.33}WO_3$ fine particle powder [$n_{Cs}/n_W(T)$ expressing the ratio of Cs atoms to W atoms is 0.33], while changing the [T-S distance] condition and the pressure P condition of the sputtering gas during the film formation by sputtering, with [T-S distance] and the pressure P (Pa) of the sputtering gas. The above [T-S distance] condition was set to 66 mm, 100 mm, and 134 mm, and the above pressure P condition was set to 0.2 (Pa), 0.6 (Pa), and 0.8 (Pa). As presented in Fig. 2, it is observed that $n_{Cs}/n_W(film)$ in the cesium tungsten oxide film becomes significantly smaller than 0.33 as [T-S distance] becomes longer and the pressure P (Pa) of the sputtering gas becomes higher. The sputtering method for the cesium tungsten oxide film was reactive sputtering using the sputtering gas containing a mixture of argon and oxygen (the method with reaction with the oxygen contained in the sputtering gas during film formation), and a mixture gas containing 5% of oxygen and the balance argon was used as the above sputtering gas.

The sputtering target used in the tests was obtained as follows.

First, a $Cs_{0.33}WO_3$ fine particle powder manufactured by Sumitomo Metal Mining Co., Ltd. was put into a hot pressing device and sintered under conditions at a temperature of 950°C and a pressing pressure of 25 MPa in a vacuum atmosphere to fabricate a cesium tungsten oxide sintered compact. As a result of chemical analysis of the composition of the sintered compact, Cs/W, which is a value of cesium Cs per 1 tungsten (W), was 0.33 [$n_{Cs}/n_W$ expressing the ratio of Cs atoms to W atoms was 0.33].

Then, the above oxide sintered compact was ground by machining to a diameter of 4 inches and a thickness of 5 mm, and bonded to a stainless steel backing plate using a metallic indium brazing material to obtain the sputtering target.

Here, in general, the composition ratio of metal elements contained in a sputtering film is known to be equal to the composition ratio of the metal elements contained in the sputtering target used. For example, in the case of film formation by sputtering using a sputtering target composed of a Ni-Cr alloy containing 80 atom% of Ni and 20 atom% of Cr, the obtained sputtering film contains 80 atom% of Ni and 20 atom% of Cr.

However, in the case of a cesium tungsten oxide, the composition ratio [$n_{Cs}/n_W(T)$] in the cesium tungsten oxide constituting the sputtering target is not equal to the composition ratio [$n_{Cs}/n_W(film)$] in the formed cesium tungsten oxide as described above.

Here, since the film formation of the cesium tungsten oxide film by sputtering used a mixture gas of argon and oxygen as the sputtering gas as described above, the oxygen content in the sputtering gas was considered to influence the composition ratio [$n_{Cs}/n_W(film)$], but the influence by the oxygen content was not observed at all. Specifically, a graph in Fig. 3 presents a relationship of $n_{Cs}/n_W(film)$ of each of formed sputtering films (cesium tungsten oxide films) with [T-S distance] and the oxygen content (%) in the sputtering gas, where the sputtering films were formed by using a sputtering target produced by sintering a $Cs_{0.33}WO_3$ fine particle powder while setting the distance [T-S distance] between the sputtering target and the substrate for film formation to 66 mm, 100 mm, and 134 mm and setting the pressure P of a sputtering gas to 0.6 (Pa). From the graph in Fig. 3, it was confirmed that the oxygen content in the sputtering gas did not influence the composition ratio [$n_{Cs}/n_W(film)$] in the cesium tungsten oxide film.

Here, $n_{Cs}/n_W(film)$ in Figs. 2 and 3 expressing the ratio of Cs atoms to W atoms in the sputtering film (cesium tungsten oxide film) was obtained by measuring the above sputtering film (cesium tungsten oxide film) by ICP optical emission spectrometry.

3. Reason for Change in Composition Ratio [$n_{Cs}/n_W(film)$] in Cesium Tungsten Oxide Film

The film formation by sputtering is carried out in a procedure where ions of the sputtering gas collide with the sputtering target, atoms on the surface of the target are ejected by the collision, and the ejected atoms reach the substrate for film formation (for example, a glass substrate).

What is important in the film formation by sputtering is the mean free path of atoms ejected from the sputtering target. The mean free path is a mean of distances each traveled by an ejected atom before colliding with another atom.

The mean free path is proportional to a temperature, inversely proportional to the square of the atomic diameter, and inversely proportional to a pressure. The atomic diameter of cesium is 476 Å and the atomic diameter of tungsten is 300 Å. Judging from these atomic diameters, the mean free path of cesium is significantly shorter than that of tungsten. In addition, the higher the pressure, the shorter the mean free path. For this reason, when the pressure in the atmosphere during film formation by sputtering is low, cesium and tungsten have no difference in the ease of reaching the substrate. However, when the pressure in the atmosphere is high, it is more difficult for cesium with a short mean free path to reach the substrate for film formation. Similarly, when the distance [T-S distance] between the sputtering target and the substrate for film formation is long, it is more difficult for cesium with a short mean free path to reach the substrate for film formation. This is presented in the graph in Fig. 2.

4. Method for Ameliorating Change in Composition Ratio [$n_{Cs}/n_W$(film)]

In film formation by sputtering, the pressure in the atmosphere and the distance [T-S distance] between the sputtering target and the substrate for film formation during film formation may be adjusted in order to optimize the sputtering film formed on the substrate for film formation. As a result, $n_{Cs}/n_W$(film) expressing the ratio of Cs atoms to W atoms in the sputtering film (cesium tungsten oxide film) may become a value lower than around 0.33, the high transmittance in the visible wavelength region and the absorption in the near-infrared wavelength region, which are the properties of the sputtering film (cesium tungsten oxide film), may deteriorate. In this case, an amount of cesium contained in the sputtering target may be increased in order that the above $n_{Cs}/n_W$(film) in the cesium tungsten oxide film can become a value around 0.33. To this end, it is necessary to clearly determine how much the amount of cesium added should be increased [in other words, $n_{Cs}/n_W$(T) expressing the ratio of cesium atoms to tungsten atoms, where $n_W$ denotes the number of tungsten atoms and $n_{Cs}$ denotes the number of cesium atoms contained in the sputtering target.

As a result of repeating a sputtering experiment, the present inventor found out the following (Formula 1) for a sputtering target that makes it possible to set $n_{Cs}/n_W$(film) expressing the ratio of Cs atoms to W atoms in a cesium tungsten oxide film within the desired range (0.3 or more to 0.36 or less).

$$0.09/\{(-000161 \times [\text{T-S distance}] + 0.00559) \times P + 0.346\}$$

$$\leq n_{Cs}/n_W(\text{T}) \leq$$

$$0.13/\{(-000161 \times [\text{T-S distance}] + 0.00559) \times P + 0.346\} \quad (\text{Formula 1})$$

This formula will be described below.

(1) The graph in Fig. 2 presents the relationship of $n_{Cs}/n_W$(film) in each of the cesium tungsten oxide films, which were formed by sputtering using the sputtering target produced by sintering the $Cs_{0.33}WO_3$ fine particle powder [$n_{Cs}/n_W$(T) expressing a ratio of Cs atoms to W atoms is 0.33] while changing the [T-S distance] condition and the pressure P condition of the sputtering gas during the film formation by sputtering, with [T-S distance] and the pressure P (Pa) of the sputtering gas. Here, the above [T-S distance] condition was set to 66 mm, 100 mm, and 134 mm, and the above pressure P condition was set to 0.2 (Pa), 0.6 (Pa), and 0.8 (Pa).

A regression (regression equation) expressing each relationship between "the pressure P (Pa) of the sputtering gas" and "$n_{Cs}/n_W$(film) in the sputtering film" in Fig. 2 is (First Equation) presented below.

$$n_{Cs}/n_W(\text{film}) = aP + 0.346 \quad (\text{First Equation})$$

In the above equation, a denotes a slope of the regression (regression equation) expressed by (First Equation).
Then, a straight line for [T-S distance] of 66 mm is calculated by the least-squares method,

$$n_{Cs}/n_W(\text{film}) = -0.0981P + 0.346 \quad (\text{First Equation 1})$$

multiple correlation coefficient 0.995 and slope(a) = -0.0981;

similarly, a straight line for [T-S distance] of 100 mm is calculated by the least-squares method,

$$n_{Cs}/n_W(film) = -0.1596P + 0.346 \quad (First\ Equation\ 2)$$

multiple correlation coefficient 0.999 and slope(a) = -0.1596; and
a straight line for [T-S distance] of 134 mm is calculated by the least-squares method,

$$n_{Cs}/n_W(film) = -0.2073P + 0.346 \quad (First\ Equation\ 3)$$

multiple correlation coefficient 0.994 and slope(a) = -0.2073.

(2) Next, a graph in Fig. 4 presents a relationship between [T-S distance] presented in Fig. 2 and the slope (a) of the regression (regression equations) expressing the relationship between the pressure P (Pa) of the sputtering gas and $n_{Cs}/n_W$(film) in the sputtering film (cesium tungsten oxide film) in Fig. 2. The regression (regression equation) expressing the above relationship between the slope (a) and [T-S distance] is (Second Equation) presented below.

$$a = -000161[T\text{-}S\ distance] + 0.00559 \quad (Second\ Equation)$$

(3) Then, the following relational expression (Third Equation) is derived by substituting (Second Equation) into (First Equation).

$$n_{Cs}/n_W(film) = (-000161[T\text{-}S\ distance] + 0.00559) \times P + 0.346$$
$$(Third\ Equation)$$

Here, (Third Equation) derived from the graphs in Figs. 2 and 4 expresses the relationship of the experimental values of $n_{Cs}/n_W$(film) in the sputtering films (cesium tungsten oxide films) with the [T-S distance] and the pressure P of the sputtering gas during the film formation by sputtering, the sputtering films (cesium tungsten oxide films) formed by using the sputtering target produced by sintering the $Cs_{0.33}WO_3$ fine particle powder [$n_{Cs}/n_W$(T) expressing the ratio of Cs atoms to W atoms is 0.33].

(4) The above $n_{Cs}/n_W$(film) in the sputtering film (cesium tungsten oxide film) and the above $n_{Cs}/n_W$(T) in the sputtering target have a relationship expressed by the following (Fourth Equation) where $\alpha$ denotes $n_{Cs}/n_W$(film) in a targeted sputtering film (cesium tungsten oxide film).

$$[n_{Cs}/n_W(T)]/\alpha = \alpha/[n_{Cs}/n_W(film)] \quad (Fourth\ Equation)$$

The left side of (Fourth Equation) expresses a compositional deviation between a "composition ratio of an objective sputtering target" and the "composition ratio $\alpha$ of the targeted sputtering film" and the right side of (Fourth Equation) expresses a compositional deviation between a "composition ratio $\alpha$ of the sputtering target set to equal to the composition ratio of the targeted sputtering film) and a "composition ratio (experimental value) of the sputtering film examined in the experiment". The left side and the right side are equalized because the "composition ratio of the objective sputtering target" in the left side, that is, the composition ratio [$n_{Cs}/n_W$(T)] of the sputtering target to be produced is determined in consideration of the compositional deviation between the "composition ratio $\alpha$ of the sputtering target" and the "composition ratio (experimental value) of the sputtering film examined in the experiment" in the right side.

Then, (Fifth Equation) is obtained by rewriting (Fourth Equation).

$$n_{Cs}/n_W(T) = \alpha^2/[n_{Cs}/n_W(film)] \quad \text{(Fifth Equation)}$$

(5) Next, (Sixth Equation) is derived by substituting (Third Equation) into (Fifth Equation).

$$n_{Cs}/n_W(T) =$$

$$\alpha^2/\{(-000161 \times [\text{T-S distance}] + 0.00559) \times P +$$

$$0.346\} \quad \text{(Sixth Equation)}$$

(6) Further, since $\alpha[n_{Cs}/n_W(film)$ of the targeted cesium tungsten oxide film] has to be set within the desired range (0.3 or more to 0.36 or less) so that the cesium tungsten oxide film can exhibit high transmittance in the visible wavelength region and absorption in the near-infrared wavelength region, (6-1) the lower limit value of $n_{Cs}/n_W(T)$ is obtained by substituting "0.3" into $\alpha$ in (Sixth Equation):

$$n_{Cs}/n_W(T) = (0.3)^2/[(-000161 \times [\text{T-S distance}] + 0.00559)$$

$$\times P + 0.346]$$

$$= 0.09/[(-000161 \times [\text{T-S distance}] + 0.00559)$$

$$\times P + 0.346],$$

and
(6-2) the upper limit value of $n_{Cs}/n_W(T)$ is obtained by substituting "0.36" into $\alpha$ in (Sixth Equation):

$$n_{Cs}/n_W(T) = (0.36)^2/[(-000161 \times [\text{T-S distance}] +$$

$$0.00559) \times P + 0.346]$$

$$= 0.13/[(-000161 \times [\text{T-S distance}] + 0.00559)$$

$$\times P + 0.346].$$

(7) In sum, the following (Formula 1) for a sputtering target is derived such that the above $n_{Cs}/n_W(film)$ of the cesium tungsten oxide film can be set within the desired range (0.3 or more to 0.36 or less).

$$0.09/\{(-000161 \times [\text{T-S distance}] + 0.00559) \times P +$$

$$0.346\}$$

$$\leq n_{Cs}/n_W(T) \leq$$

$$0.13/\{(-000161 \times [\text{T-S distance}] + 0.00559) \times P +$$

$$0.346\} \quad \text{(Formula 1)}$$

In (Formula 1), [T-S distance] denotes the distance between the sputtering target and the substrate for film formation and P denotes the pressure in the atmosphere during film formation by sputtering, and in $n_{Cs}/n_W$, $n_{Cs}$ denotes the number of Cs atoms contained in the sputtering target and $n_W$ denotes the number of W atoms contained in the sputtering target.

5. Method for Producing Sputtering Target

The sputtering target according to the present invention can be produced by using a cesium tungsten oxide powder which are made of raw materials, that is, a metal or compound as a cesium source and a metal or compound as a tungsten source, and whose $n_{Cs}/n_W(T)$ expressing the ratio of cesium atoms to tungsten atoms is set to the composition ratio satisfying the condition defined by the above (Formula 1).

(1) Production of Cesium Tungsten Oxide Powder

The cesium source and the tungsten source are mixed so that the composition ratio satisfies the condition defined by the above (Formula 1), and the obtained mixture is heated and sintered to produce a cesium tungsten oxide powder.

As the cesium source, metals, oxides, carbonates, or chlorides may be used. Cesium oxides include $Cs_2O$, $Cs_2O_2$, $CsO_2$, $Cs_2O_3$, $Cs_{11}O_3$, $Cs_4O$ and $Cs_7O$.

As the tungsten source, metals, oxides, or carbides may be used. As a tungsten oxide, $W_3O$, $WO_2$, $W_{20}O_{58}$, or $WO_3$ may be used.

As the oxides as the cesium source and the tungsten source, hydrates may be used.

For example, a cesium tungsten oxide powder can be produced by: preparing a precursor of a cesium tungsten oxide by mixing an aqueous solution of ammonium metatungstate and cesium chloride so that the composition ratio satisfies the condition defined by the above (Formula 1) and drying the obtained mixture at 100°C or higher to remove water; and sintering the precursor under the condition at a temperature of 500°C or higher. Instead, a precursor can be also produced by drying an aqueous solution of tungstic acid and cesium carbonate. The atmosphere for sintering the precursor may be a reduced atmosphere in which argon and hydrogen are mixed or may be an ambient atmosphere.

(2) Production of Sputtering Target according to Present Invention

A sintered compact can be obtained by filling a mold with the above cesium tungsten oxide powder, molding it into the shape of a sputtering target, and then sintering it by a hot pressing method or a hot isostatic pressing method.

The conditions for sintering the mold filled with the cesium tungsten oxide powder by the hot pressing method or the hot isostatic pressing method are hot pressing or hot isostatic pressing with a pressure of 20 MPa or higher in a vacuum or inert atmosphere at a sintering temperature of 700°C or higher to 1300°C or lower.

The obtained sintered compact is ground by machining to obtain a sputtering target according to the present invention.

The production procedure of pressing and sintering the sputtering target can be applied to both of a flat-plate-shaped target and a cylindrical target. The flat-plate-shaped target is fixed to a backing plate and the cylindrical target is fixed to a backing tube for use in film formation by sputtering.

In addition, the cylindrical target may be finished as a rotary target by: forming a base layer selected from a nickel-aluminum alloy, a nickel-chromium alloy, a copper-aluminum alloy, a copper-zinc alloy, and the like by thermal spraying on a backing tube whose surface is roughened by blasting; directly thermal-spraying the cesium tungsten oxide powder to form a thermally sprayed film (target film) with a thickness of 5 mm to 20 mm; and then polishing the above thermally sprayed film (target film).

If the sputtering target is, for example, a conductor with a specific resistance of 1 Ω·cm or less, a highly productive DC sputtering apparatus can be used.

6. Film Formation by Sputtering

A cesium tungsten oxide film can be produced by mounting the obtained sputtering target in a sputtering film-formation apparatus and performing film formation by sputtering on a glass substrate or the like as a substrate for film formation.

The sputtering conditions are set to [T-S distance] and the pressure P of the sputtering gas used to determine the composition ratio $n_{Cs}/n_W(T)$ of the sputtering target, as a matter of course.

Here, the pressure P of the sputtering gas is desirably 0.2 Pa or higher to 0.8 Pa or lower. When the pressure P is lower than 0.2 Pa, the sputtering rate (efficiency) is decreased because little argon is ionized. On the other hand, when the pressure P exceeds 0.8 Pa, the plasma during sputtering may be unstable.

Meanwhile, [T-S distance] is desirably 60 mm or longer to 140 mm or shorter. For film formation by sputtering on a large-size substrate, [T-S distance] is about 100 mm.

After the film is formed, heat treatment is performed to obtain the glass substrate on which an infrared shielding film made of the cesium tungsten oxide film is formed. The atmosphere condition for the heat treatment has to be changed depending on a ratio of the oxygen gas contained in the sputtering gas, and an oxidizing atmosphere, an inert gas atmosphere, or a reducing atmosphere containing a reducing gas such as hydrogen is selected. For example, when the oxygen content in the sputtering gas is 0% or more to less than 1%, the heat treatment is performed in an oxidizing atmosphere, and a mixture gas of ambient atmosphere, 5 to 20% of oxygen, and nitrogen, for example, is selected as the oxidizing atmosphere. Meanwhile, the oxygen content in the sputtering gas is 1% or more, the heat treatment is performed in a reducing atmosphere of a nitrogen gas or the like. Example

Hereinafter, Example of the present invention will be specifically described.

Here, as a sputtering apparatus, an apparatus equipped with a DC magnetron sputtering cathode and a substrate holder in a film forming chamber was used.

Then, the distance [T-S distance] between the sputtering target and the substrate was set to 100 mm, an argon-mixed gas containing 5% of oxygen was used as the sputtering gas, and the pressure P of the sputtering gas during film formation by sputtering was adjusted to 0.6 Pa.

In addition, a target value of $n_{Cs}/n_W$(film) in a cesium tungsten oxide film was set to 0.33, and $n_{Cs}/n_W$(T) of the sputtering target was calculated as 0.431 by substituting [T-S distance] = 100 mm, P = 0.6 Pa, and $\alpha$ = 0.33 into (Sixth Equation).

$$n_{Cs}/n_W(T) = \alpha^2/\{(-000161 \times [\text{T-S distance}] + 0.00559) \times P + 0.346\} \quad (\text{Sixth Equation})$$

[Example 1]

(1) Production of Cesium Tungsten Oxide Powder

A cesium carbonate solution was obtained by dissolving 9.70 kg of cesium carbonate ($Cs_2CO_3$) in 6.70 kg of water. This solution was added to 34.57 kg of tungstic acid ($H_2WO_4$), followed by thoroughly stirring and mixing, and then drying with stirring to obtain a dry product. Here, $n_{Cs}/n_W$ expressing the ratio of Cs atoms to W atoms contained in the dry product was equivalent to 0.431.

Next, while a 5 vol% $H_2$ gas with a $N_2$ gas used as a carrier was supplied, the above dry product was heated and sintered at a temperature of 800°C for 5.5 hours. After that, the supplied gas was switched to only the $N_2$ gas and the temperature was lowered to room temperature to obtain the cesium tungsten oxide powder.

(2) Production of Sputtering Target

The obtained cesium tungsten oxide powder was put in a hot pressing device and sintered under conditions at a temperature of 950°C and a pressing pressure of 25 MPa in a vacuum atmosphere to fabricate a cesium tungsten oxide sintered compact. As a result of chemical analysis of the fabricated sintered compact, $n_{Cs}/n_W$ expressing the ratio of Cs atoms to W atoms contained in the sintered compact was 0.43.

Then, the obtained cesium tungsten oxide sintered compact was ground by machining to a diameter of 4 inches and a thickness of 5 mm, and bonded to a stainless steel backing plate using a metallic indium brazing material to obtain a sputtering target according to Example.

(3) Production of Infrared Shielding Film Formed of Cesium Tungsten Oxide Film

A 4-inch quartz wafer was used as a substrate for film formation and the quartz wafer was heated at 300°C with a near-infrared heater.

Then, the air in the film forming chamber and the substrate stocker chamber of the sputtering apparatus was vacuum-exhausted to $5 \times 10^{-4}$ Pa or less, an argon gas (sputtering gas) mixed with 5% of oxygen was introduced at 200 sccm into the above film forming chamber, and the pressure of the sputtering gas was adjusted to 0.6 Pa. After that, the cesium tungsten oxide film was formed on the quartz wafer by a reactive sputtering method.

As result of ICP analysis of the formed cesium tungsten oxide film, $n_{Cs}/n_W$(film) expressing the ratio of Cs atoms to W atoms in the cesium tungsten oxide film was 0.32 that was approximately the target value. Here, the film thickness of the cesium tungsten oxide film was 400 nm.

Next, the cesium tungsten oxide film was annealed in a nitrogen gas reducing atmosphere at 600°C for 10 minutes to obtain an infrared shielding film formed of the cesium tungsten oxide film.

(4) Transmittance of Infrared Shielding Film

The transmittance of the obtained infrared shielding film was measured with a spectrophotometer (manufactured by Hitachi, Ltd., model number V-670) and the spectral optical properties presented in a graph in Fig. 5 were obtained.

From the graph in Fig. 5, it was confirmed that this infrared shielding film had high transmittance in the visible wavelength region and absorption in the near-infrared wavelength region. In addition, due to the material composition, the infrared shielding film had radio wave transmittance.

POSSIBILITY OF INDUSTRIAL APPLICATION

Since $n_{Cs}/n_W$(film) expressing the ratio of Cs atoms to W atoms in the cesium tungsten oxide film formed by using a sputtering target according to the present invention is set within such a desired range (0.3 or more to 0.36 or less) that the film can exhibit high transmittance in the visible wavelength region and absorption in the near-infrared wavelength region, the present invention is industrially applicable to use in vehicle window glasses and the like in order to reduce the energy consumption of air conditioners in summer.

REFERENCE SIGNS LIST

1 WO$_6$ Unit
2 Element M

**Claims**

1. A sputtering target for use to form a cesium tungsten oxide film on a substrate for film formation by a sputtering method, wherein

   the sputtering target includes cesium (Cs) and tungsten (W), and
   when [T-S distance] denotes a distance between the sputtering target and the substrate for film formation and P denotes a pressure in an atmosphere during film formation by sputtering and $n_W$ denotes the number of W atoms and $n_{Cs}$ denotes the number of Cs atoms contained in the sputtering target,
   $n_{Cs}/n_W$(T) expressing a ratio of Cs atoms to W atoms in the sputtering target satisfies the following (Formula 1) with respect to [T-S distance] and P defined above:

   ```
   0.09/{(-000161 × [T-S distance] + 0.00559) × P +

   0.346}

                ≤ n_Cs/n_W(T) ≤

   0.13/{(-000161 × [T-S distance] + 0.00559) × P +

   0.346}       (Formula 1).
   ```

2. The sputtering target according to claim 1, including a cesium tungsten oxide sintered compact produced from a cesium tungsten oxide powder.

3. The sputtering target according to claim 1, including a thermally sprayed film of a cesium tungsten oxide powder.

4. The sputtering target according to claim 2 or 3, wherein
   the cesium tungsten oxide powder is made of raw materials which are a metal or compound as a cesium source and a metal or compound as a tungsten source.

5. The sputtering target according to claim 4, wherein
   the compound as the cesium source includes an oxide, a carbonate, or a chloride.

**6.** The sputtering target according to claim 4, wherein
the compound as the tungsten source includes an oxide or a carbonate.

**7.** A method for forming a cesium tungsten oxide film on a substrate for film formation by using the sputtering target according to any one of claims 1 to 6, wherein
the distance [T-S distance] between the sputtering target and the substrate for film formation during the film formation by sputtering is 60 mm or longer to 140 mm or shorter.

**8.** The method for forming a cesium tungsten oxide film according to claim 7, wherein
the pressure P in the atmosphere during the film formation by sputtering is 0.2 Pa or higher to 0.8 Pa or lower.


**Amended claims under Art. 19.1 PCT**

**1.** (Amended) A method for forming a cesium tungsten oxide film on a substrate for film formation by using a sputtering target including cesium (Cs) and tungsten (W), wherein

when [T-S distance] denotes a distance between the sputtering target and the substrate for film formation and P denotes a pressure in an atmosphere during film formation by sputtering and $n_W$ denotes the number of W atoms and $n_{Cs}$ denotes the number of Cs atoms contained in the sputtering target,
$n_{Cs}/n_W(T)$ expressing a ratio of Cs atoms to W atoms in the sputtering target satisfies the following (Formula 1) with respect to [T-S distance] and P defined above:

$$0.09/\{(-000161 \times [\text{T-S distance}] + 0.00559) \times P + 0.346\}$$

$$\leq n_{Cs}/n_W(T) \leq$$

$$0.13/\{(-000161 \times [\text{T-S distance}] + 0.00559) \times P + 0.346\} \quad (\text{Formula 1}).$$

**2.** (Amended) The method for forming a cesium tungsten oxide film according to claim 1, wherein
the sputtering target includes a cesium tungsten oxide sintered compact produced from a cesium tungsten oxide powder.

**3.** (Amended) The method for forming a cesium tungsten oxide film according to claim 1, wherein
the sputtering target includes a thermally sprayed film of a cesium tungsten oxide powder.

**4.** (Amended) The method for forming a cesium tungsten oxide film according to claim 2 or 3, wherein
the cesium tungsten oxide powder is made of raw materials which are a metal or compound as a cesium source and a metal or compound as a tungsten source.

**5.** (Amended) The method for forming a cesium tungsten oxide film according to claim 4, wherein
the compound as the cesium source includes an oxide, a carbonate, or a chloride.

**6.** (Amended) The method for forming a cesium tungsten oxide film according to claim 4, wherein
the compound as the tungsten source includes an oxide or a carbonate.

**7.** (Amended) The method for forming a cesium tungsten oxide film according to any one of claims 1 to 6, wherein
the distance [T-S distance] between the sputtering target and the substrate for film formation during the film formation by sputtering is 60 mm or longer to 140 mm or shorter.

**8.** (Amended) The method for forming a cesium tungsten oxide film according to claim 7, wherein
the pressure P in the atmosphere during the film formation by sputtering is 0.2 Pa or higher to 0.8 Pa or lower.

**Statement under Art. 19.1 PCT**

1. is amended by: replacing a structure of a sputtering target according to claim 1 before amendment with a method for forming a cesium tungsten oxide film on a substrate for film formation by using a sputtering target including cesium (Cs) and tungsten (W), and

a requirement that, when [T-S distance] denotes a distance between the sputtering target and the substrate for film formation and P denotes a pressure in an atmosphere during film formation by sputtering and $n_W$ denotes the number of W atoms and $n_{Cs}$ denotes the number of Cs atoms contained in the sputtering target, $n_{Cs}/n_W(T)$ expressing a ratio of Cs atoms to W atoms in the sputtering target satisfies the following (Formula 1) with respect to [T-S distance] and P defined above:

$$0.09/\{(-000161 \times [\text{T-S distance}] + 0.00559) \times P + 0.346\}$$

$$\leq n_{Cs}/n_W(T) \leq$$

$$0.13/\{(-000161 \times [\text{T-S distance}] + 0.00559) \times P + 0.346\} \quad (\text{Formula 1})$$

is clarified.

Meanwhile, none of Cited Documents contain any description of the requirement that, when [T-S distance] denotes a distance between the sputtering target and the substrate for film formation and P denotes a pressure in an atmosphere during film formation by sputtering and $n_W$ denotes the number of W atoms and $n_{Cs}$ denotes the number of Cs atoms contained in the sputtering target, $n_{Cs}/n_W(T)$ expressing a ratio of Cs atoms to W atoms in the sputtering target satisfies the above (Formula 1) with respect to [T-S distance] and P.

According to the method for forming a cesium tungsten oxide film according to the present invention, $n_{Cs}/n_W(T)$ expressing the ratio of Cs atoms to W atoms in the sputtering target satisfies the above (Formula 1) with respect to [T-S distance] and P. For this reason, the method produces an effect of making it possible to set $n_{Cs}/n_W(\text{film})$ expressing the ratio of Cs atoms to W atoms in a cesium tungsten oxide film within such a desired range (0.3 or more to 0.36 or less) that the obtained film can exhibit high transmittance in the visible wavelength region and absorption in the near-infrared wavelength region.

# FIG.1

# FIG.2

# FIG.3

───○─── [T-S DISTANCE]: 66mm
───●─── [T-S DISTANCE]:100mm
───◉─── [T-S DISTANCE]:134mm

FIG.4

[T-S DISTANCE]

SLOPE (a) OF REGRESSION EQUATION EXPRESSING RELATIONSHIP BETWEEN PRESSURE P (Pa) AND $n_{os}/n_w$(film)

# FIG.5

TRANSMITTANCE (FILM THICKNESS: 400nm)

## INTERNATIONAL SEARCH REPORT

| | International application No. |
|---|---|
| | **PCT/JP2022/006841** |

| A. | CLASSIFICATION OF SUBJECT MATTER |
|---|---|

*C23C 14/34*(2006.01)i; *C04B 35/495*(2006.01)i; *G02B 5/22*(2006.01)i
FI: C23C14/34 R; C23C14/34 A; C04B35/495; G02B5/22

According to International Patent Classification (IPC) or to both national classification and IPC

| B. | FIELDS SEARCHED |
|---|---|

Minimum documentation searched (classification system followed by classification symbols)

C23C14/34; C04B35/495; G02B5/22

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2021-31327 A (SUMITOMO METAL MINING CO., LTD.) 01 March 2021 (2021-03-01) claims 1-4, paragraphs [0024]-[0036] | 1-8 |
| X | JP 2020-66558 A (SUMITOMO METAL MINING CO., LTD.) 30 April 2020 (2020-04-30) claims 1, 5, paragraphs [0033]-[0035] | 1-2, 4-8 |
| A | | 3 |
| X | JP 6788236 B1 (SUMITOMO METAL MINING CO., LTD.) 25 November 2020 (2020-11-25) claims 1-7, paragraphs [0078]-[0079] | 1, 3, 4-8 |
| A | | 2 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 April 2022** | **19 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/006841**

| Patent document cited in search report | | | Publication date (day/month/year) | Patent family member(s) | Publication date (day/month/year) |
|---|---|---|---|---|---|
| JP | 2021-31327 | A | 01 March 2021 | (Family: none) | |
| JP | 2020-66558 | A | 30 April 2020 | (Family: none) | |
| JP | 6788236 | B1 | 25 November 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05113085 B
- JP 4096205 B
- JP 2002020142 A
- JP 6540859 B